# EUROPEAN PATENT SPECIFICATION

(11) **EP 4 532 982 B1**
(45) Date of publication and mention of the grant of the patent: **18.02.2026**
(21) Application number: 23726410.6
(22) Date of filing: 17.05.2023
(51) Int. Cl.: F21V 23/02, F21S 4/24, H05K 1/18, F21Y 115/10, F21Y 103/10

(54) **AN ELECTRONIC DEVICE COMPRISING AN ELONGATE SUBSTRATE ARRANGEMENT**
ELEKTRONISCHE VORRICHTUNG MIT EINER LÄNGLICHEN SUBSTRATANORDNUNG
DISPOSITIF ÉLECTRONIQUE COMPRENANT UN AGENCEMENT DE SUBSTRAT ALLONGÉ

(30) Priority: 25.05.2022 WO PCT/CN2022/094979; 17.06.2022 EP 22179707
(43) Date of publication of application: 09.04.2025
(73) Proprietor: Signify Holding B.V., 5656 AE Eindhoven (NL)
(72) Inventor: YANG, Yongjun, 5656 AE Eindhoven (NL); DONG, Ping, 5656 AE Eindhoven (NL); REN, Xiaoyong, 5656 AE Eindhoven (NL); ZHANG, Hanming, 5656 AE Eindhoven (NL)
(74) Representative: Verweij, Petronella Daniëlle
(86) International application number: PCT/EP2023/063392
(87) International publication number: WO 2023/227458

(56) References cited:
- EP-A1- 3 093 552
- EP-A2- 0 911 573
- DE-A1- 102005 015 656
- DE-A1- 102020 121 515
- DE-U1- 202019 101 494
- JP-B1- 3 798 804
- US-A1- 2020 108 768
- US-A1- 2020 343 770
- US-B1- 10 928 017
- US-B2- 10 847 692

## Description

### FIELD OF THE INVENTION

This invention relates to electronic devices having an elongate substrate. For example, it relates to devices formed as strips, such as light strips.

### BACKGROUND OF THE INVENTION

Electronic devices formed as strips may require some processing after initial manufacture, such as to bend the strip into a desired shape, or separate the strip into a plurality of shorter strips which each function as a separate independent unit.

For light strips, there is for example a flexible printed circuit on which LED chips are mounted and an insulating coating, in particular a silica gel tube, around the flexible printed circuit. In the past, they were manufactured separately and then assembled into a light strip. A co-extrusion process is now used, which improves the productivity and enables an improved and more uniform lighting effect.

To increase the productivity and decrease the waste of silica gel, light strips which pass through the co-extrusion process are typically longer than 50 meters, including 10 to 30 individual light strips. After co-extrusion, this long light strip assembly needs to be split into the individual units. However, it is difficult to find the joint position of the adjacent light strips. One option is to operate a light strip controller to light up the start or end of the light strip to find the joint position and then cut off that light strip. The next one then is powered up, and so on until all the light strips are split off. This is inefficient and does not work if a light strip is damaged.

Identifying a location along an elongate printed circuit substrate may be useful for devices other than light strips, for example any devices where the strip substrate needs to be segmented or processed (e.g. shaped) at specific locations.

There is therefore a need for an improved way to identify specific locations along an elongate substrate arrangement.

Document DE202019101494U1 discloses a lighting strip of the prior art and document EP0911573A2 discloses a method of manufacturing an electronic device.

### SUMMARY OF THE INVENTION

The invention is defined by the claims.

According to examples in accordance with an aspect of the invention, there is provided an electronic device comprising:
an elongate printed circuit substrate arrangement;
a row of electrical units on the printed circuit substrate arrangement; and
an indicator unit comprising an indicator element and a wireless power receiver for wirelessly receiving power for actuating the indicator element, thereby to identify a particular location of the elongate printed circuit substrate arrangement.

This electronic device comprises a row of electrical units. An indicator element, such as a lighting element, is used to identify a location along the elongate printed substrate. This location may for example be a location at which the electronic device is to be further processed, e.g. segmented or bent.

The desired particular location can thus be indicated wirelessly using electromagnetic power transfer without the need to power the electrical units themselves. This can improve the productivity and location accuracy (e.g. for separating the elongate printed circuit substrate) enormously.

According to the invention, the row of electrical units comprises multiple sets of electrical units which are to be separated into the individual sets (each forming an end device), and the indicator unit identifies the location at which separation is to take place. After separation, the indicator units may be removed or they may remain part of the separated end devices.

Alternatively, in an embodiment not covered by the claims, the device may comprise a single set of electrical units and the indicator unit has previously been used to identify a location at which the device has been separated from a longer printed circuit substrate formed of multiple such devices. In this case, the indicator unit is integrated with the electrical units and thus remains in place as part of the finished end device.

The printed circuit substrate arrangement for example comprises one or more flexible printed circuits.

As mentioned above, the row of electrical units comprises multiple sets of electrical units which are to be separated, and the indicator unit identifies the location at which separation is to take place. The indicator unit may then be provided between each adjacent pair of sets of electrical units along the elongate printed circuit substrate arrangement.

Each set of electrical units (which will form a single end device) has its own individual printed circuit substrate, and the individual printed circuit substrates are connected together to form the elongate printed circuit substrate arrangement. Thus, multiple substrates (e.g. 2m to 5m long) are assembled together to form the elongate substrate arrangement (e.g. to form a length of over 50m), and separation is required after processing of that elongate substrate arrangement.

Each individual printed circuit substrate may carry at least one indicator unit. Thus, the indicator units may be an integral part of the individual devices.

Instead, the indicator units may comprise separate devices to the individual printed circuit substrates with separate printed circuit substrates. The individual printed circuit substrates and the separate printed circuit substrates are in that case connected together to form the elongate printed circuit substrate arrangement.

The connections of the substrates for example includes electrical connections for example to enable testing of the full length strip assembly.

In preferred examples, the indicator element comprises a lighting element. Thus, the particular location is identified visually. The location may instead be identified electronically, for example using an RFID tag approach. The tag is wirelessly powered and then responds with a reply signal when located at the location of a wireless interrogation signal.

The device may comprise a co-extruded flexible printed circuit arrangement and insulating coating, such as a sleeve. An extrusion process is thus used to provide a sleeve around the electronic device. The insulating sleeve for example comprises a silica gel tube. By forming a long elongate printed substrate arrangement and separating the devices afterwards, an efficient co-extrusion process is enabled.

The device for example comprises a light strip, wherein each electrical unit comprises a LED. A set of LEDs defines a single light strip, but the overall elongate substrate arrangement may include a chain of these individual light strips.

The present disclosure also provides an indicator unit for interposing between individual printed circuit substrates, thereby to form an elongate printed circuit substrate arrangement, the indicator unit comprising an indicator element and a wireless power receiver for wirelessly receiving power for actuating the indictor element, thereby to identify a junction between the individual printed circuit substrates.

This is the unit which can be interposed between individual substrates (of the individual end devices) to form the elongate substrate arrangement.

Within the electronic device or the indicator unit, the wireless power receiver for example comprises a receiver inductor and an AC/DC converter and the indicator element comprises a LED. When the device comprises light strips, each comprising a set of LEDs, the overall device for example comprises 10 to 30 individual light strips.

The invention also provides a method of manufacturing an electronic device, comprising:
manufacturing an elongate substrate arrangement comprising:
   a row of electrical units; and
   an indicator unit comprising an indicator element and a wireless power receiver for wirelessly receiving power for actuating the indicator element thereby to identify a location of the elongate printed circuit substrate arrangement;
passing the elongate printed circuit substrate arrangement over a wireless power transmitter;
observing the actuation of the indicator element as it passes over the wireless power transmitter; and
marking the location of the indicator element, thereby to identify the location indicated by the indicator element.

The marked location is then used for further processing, such as cutting or bending.

The method may comprise assembling a plurality of individual printed circuit substrates each carrying a respective set of electrical units to form the elongate printed circuit substrate arrangement, wherein each individual printed circuit substrate carries at least one indicator element. In this case, the end devices each incorporate the indicator units.

The method may instead comprise assembling a plurality of individual printed circuit substrates and separate printed circuit substrates of the indicator units to form the elongate printed circuit substrate arrangement. In this case, separate indicator units are interposed between the individual end devices.

The method may comprise co-extruding the flexible printed circuit arrangement and an insulating coating.

The method is preferably for manufacturing a light strip, wherein each electrical unit comprises a LED. Thus, individual printed circuit substrates may each form a light strip and the overall device may comprise 10 to 30 individual LED strips.

These and other aspects of the invention will be apparent from and elucidated with reference to the embodiment(s) described hereinafter.

### BRIEF DESCRIPTION OF THE DRAWINGS

For a better understanding of the invention, and to show more clearly how it may be carried into effect, reference will now be made, by way of example only, to the accompanying drawings, in which:
Fig. 1 shows a first example of an electronic device;
Fig. 2 shows an example of the circuitry of the indicator unit;
Fig. 3 shows the indicator unit in perspective view;
Fig. 4 shows the indicator unit viewed from above;
Fig. 5 shows the device of Figure 1 being passed over a wireless power transmitter;
Fig. 6 is used to explain one example of cutting process; and
Fig. 7 shows that the indicator unit may be part of the light strip.

### DETAILED DESCRIPTION OF THE EMBODIMENTS

The invention will be described with reference to the Figures.

It should be understood that the detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. It should be understood that the Figures are merely schematic and are not drawn to scale. It should also be understood that the same reference numerals are used throughout the Figures to indicate the same or similar parts.

The invention provides an electronic device which has an elongate printed circuit substrate arrangement and a row of electrical units on the elongate printed circuit substrate arrangement. An indicator unit is wireless powered for identifying a particular location of the elongate printed circuit substrate arrangement. This identification is used for identifying the correct location for subsequent processing of the device during manufacture.

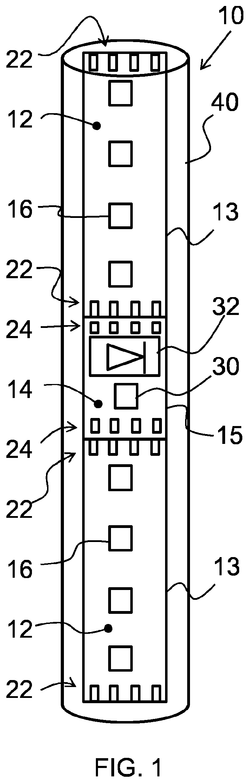

Figure 1 shows a first example of an electronic device 10, in the form of a light strip assembly. In this example, the light strip assembly comprises a series connection of multiple individual light strips which are to be separated.

The light strip assembly comprises a line of light strips 12. Each light strip 12 is an end product, and the assembly shown in Figure 1 is thus present during an intermediate stage of manufacture when these end products are connected together to simplify and reduce the cost of the manufacturing process.

In this particular example, the line of light strips comprises light strips 12 as well as indicator unit 14 interposed between the ends of adjacent light strips 12. The indicator unit 14 in one example identifies the location at which separation of the light strip assembly into the individual light strips 12 is to take place. However, the indicator unit may instead identify the location for other processes such as bending or other local operations.

Each light strip 12 has its own individual printed circuit substrate 13, in the form of a flexible printed circuit. In this text the term "individual printed circuit substrate" is used to refer to the substrate 13 for a single light strip. The indicator unit 14 in this example is a separate device to the individual light strips and hence is separate to the individual printed circuit substrates. The substrates 15 for the indicator units will be described as "separate printed circuit substrates". The individual printed circuit substrates 13 and the separate printed circuit substrates 15 are connected together to form an overall elongate printed circuit substrate arrangement. Thus the term "substrate arrangement " is used to denote either a single substrate or a connected set of substrates such as shown in Figure 1.

Thus, in the example of Figure 1, indicator units are provided between each adjacent pair of light strips along the overall elongate printed circuit substrate arrangement.

Each light strip comprises a row of individual electrical units in the form of LEDs 16. Each light strip is for example 2m to 5m long and the overall elongate printed circuit substrate arrangement may be over 50m long. Thus, the overall device may comprise 10 to 30 individual light strips.

The different substrates are connected together by terminal blocks. The light strips 12 have terminal blocks 22 and the indicator unit 14 has terminal blocks 24.

The indicator unit in a preferred example comprises a lighting unit. It comprises a lighting element 30 and a wireless power receiver 32. The wireless power receiver is for wirelessly receiving power for actuating the indicator element, i.e. illuminating the lighting element, and this illumination is used to identify a particular location of the elongate printed circuit substrate arrangement.

The location of the lighting element 30 is thus indicated wirelessly using electromagnetic power transfer without the need to power the LEDs of the light strips.

In the example of Figure 1, the overall elongate printed circuit substrate arrangement comprises multiple sets of LEDs (each set forming one light strip and hence one end device), and those sets are to be separated. The indicator unit identifies the location at which separation is to take place.

After separation, the indicator units (which have for example been cut down the middle) are removed.

The electrical connection between the different substrates by means of the terminal blocks enables testing of the full length strip. The full light strip may be too long to be tested as a single unit (due to voltage drops), so the elongate strip may be separated into shorter lengths for testing before being separated into individual end devices.

Alternatively or additionally, the individual end device strips can be tested using a standard test procedure.

The elongate printed circuit substrate is co-extruded with an insulating sleeve 40. An extrusion process is thus used to provide a sleeve around the device before the indicator unit is later used during the manufacturing process. The insulating sleeve for example comprises a silica gel tube. By forming a long elongate printed substrate arrangement and separating the devices afterwards, an efficient co-extrusion process is enabled.

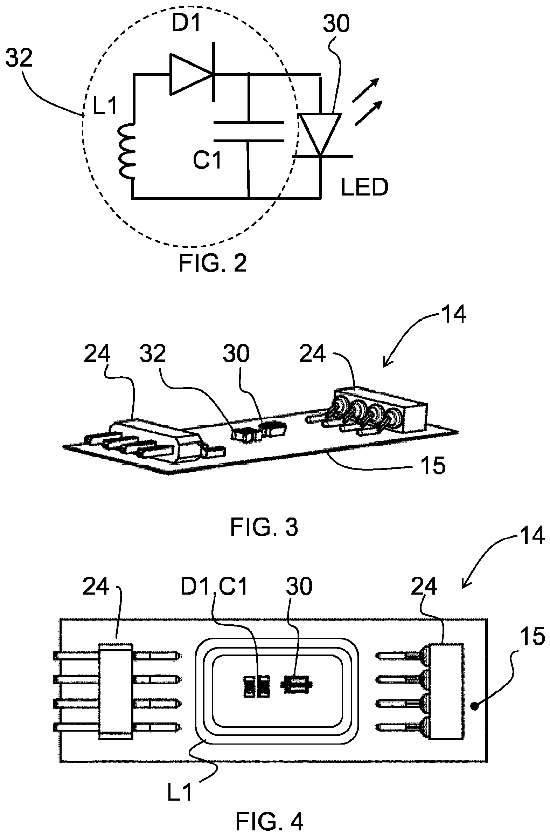

Figure 2 shows an example of the circuitry of the indicator unit. It comprises the lighting element 30 in the form of a LED and the wireless power receiver 32 in the form of an inductor pick up coil L1 and a rectifier circuit of diode D1 and capacitor C1. The capacitor is charged by the rectifier and delivers current to the lighting element 30. Of course other energy harvesting circuits may be used. The coil L1 only needs to have an inductance of ones or tens of µH.

The example of Figure 1 uses an indicator unit which is separate to the light strips. Figure 3 shows the indicator unit 14 in perspective view. It has its separate printed circuit substrate 15 on which are mounted the lighting element 30, wireless power receiver 32 and the terminal blocks 24. One terminal block is male and one is female so that the indicator unit can be interposed between corresponding opposite (male and female) ends of the light strips.

Figure 4 shows the indicator unit 14 viewed from above.

The present disclosure also relates to this indicator unit alone, for interposing between individual printed circuit substrates, thereby to form the elongate printed circuit substrate arrangement.

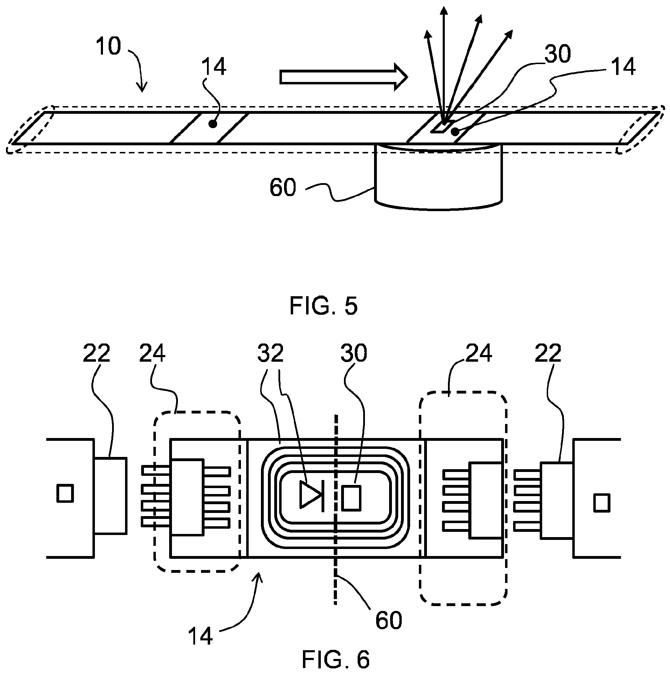

Figure 5 shows the device of Figure 1 being passed over a wireless power transmitter 60. When an indicator unit 14 reaches the wireless power transmitter, the lighting element 30 is illuminated as shown, and the position can be marked for future reference, or there may be automated detection of the light and automated further processing, e.g. cutting.

The further processing for example involves production cutting of the long length (e.g. 50m) to the individual device length (e.g. 5m). The individual devices may be cut further by the customer to a desired length for their particular application. The indicator element is typically only used by the manufacturer in this particular example. However, in other application examples, an end user could make use of the indicator elements, for example using an existing wireless power supply device.

Figure 6 shows one example of how the cutting process is carried out. The indicator unit 14 is marked and cut alone line 60. This is a coarse cutting step. Subsequently, the cut halves of the indicator unit are removed from the adjacent light strips by disconnecting the terminal blocks 24 from the terminal blocks 22. This removes the residual parts of the indicator elements. The residual insulating sleeve will also be cut. The terminal blocks will remain in the insulating sleeve.

In the example above, the indicator unit is interposed between light strips (with their own individual printed circuit substrate).

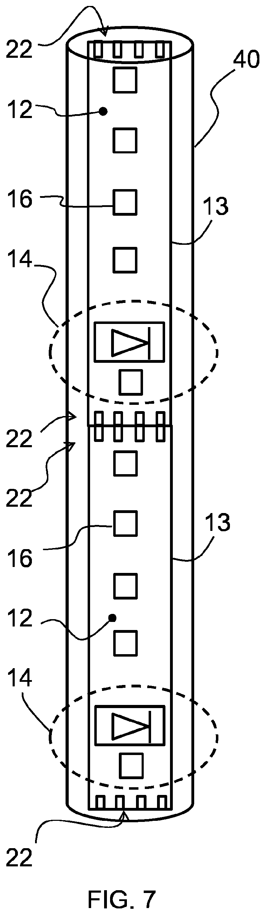

Figure 7 shows that the indicator unit 14 may instead be part of the light strip. Each light strip comprises the row of LEDs 16 and additionally the indicator element and wireless power receiver of the indicator unit 14. The light strips are connected together by their terminal blocks 22, which as in the example above comprise a male terminal block and one end and a female terminal block at the other end. Because the indicator unit is integrated with the LEDs, it remains in place as part of the end device.

In this case, the location is marked, and then only the insulating sleeve 40 needs to be cut using a cutting tool which cuts only the insulating sleeve. The individual light strips can then be separated by pulling the terminal blocks apart.

Each individual light strip in this example comprises an elongate printed circuit substrate arrangement, which includes the indicator unit to identify a particular location of the elongate printed circuit substrate arrangement. In this case, the row of electrical units (i.e. LEDs) on the printed circuit substrate arrangement corresponds to only only a single light strip (so that the elongate substrate "arrangement" has only one substrate). For a separated light strip, the indicator unit has served its purpose, in that it has previously been used to identify a location at which the device has been separated from a longer printed circuit substrate assembly formed of multiple such devices (i.e. the arrangement of Figure 7).

As explained above, a lighting element is only one possible example of the indicator element. Non-visual means may also be used, such as an indicator element in the form of an RFID tag which is wirelessly powered and then responds with a reply signal when located at the location of the wireless interrogation signal. The reply signal is then the indication provided by the indicator element.

Another example is a wirelessly powered heating element, which when actuated creates a visual change in the insulating layer e.g. a color change.

The invention is also not limited to light strips. Any electronic device which is manufactured in a long strip may need to be separated into individual components, or bent into shape, and it may be difficult to identify the appropriate locations for that separation or bending. Locations may for example be identified where the device is to be connected to another element such as a jig or other fixture.

Variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality.

The mere fact that certain measures are recited in mutually different dependent claims does not indicate that a combination of these measures cannot be used to advantage.

If the term "adapted to" is used in the claims or description, it is noted the term "adapted to" is intended to be equivalent to the term "configured to". If the term "arrangement" is used in the claims or description, it is noted the term "arrangement" is intended to be equivalent to the term "system", and vice versa.

Any reference signs in the claims should not be construed as limiting the scope.

## Claims

1. An electronic device (10) comprising:
an elongate printed circuit substrate arrangement (13,15);
a row of electrical units (16) on the printed circuit substrate arrangement; and
an indicator unit (14) comprising an indicator element (30) and a wireless power receiver (32) for wirelessly receiving power for actuating the indicator element, thereby to identify a particular location of the elongate printed circuit substrate arrangement; wherein the row of electrical units (16) comprises multiple sets of electrical units which are to be separated, and the indicator unit (14) identifies the location at which separation is to take place;
wherein each set of electrical units has its own individual printed circuit substrate (13), and the individual printed circuit substrates (13) are connected together to form the elongate printed circuit substrate arrangement.

2. The electronic device of claim 1, comprising an indicator unit (14) between each adjacent pair of sets of electrical units (16) along the elongate printed circuit substrate arrangement.

3. The electronic device of claim 1, wherein each individual printed circuit substrate (13) carries at least one indicator unit (14).

4. The electronic device of claim 1, wherein the indicator units (14) comprise separate devices to the individual printed circuit substrates with separate printed circuit substrates (15), wherein the individual printed circuit substrates (13) and the separate printed circuit substrates (15) are connected together to form the elongate printed circuit substrate arrangement (13,15).

5. The electronic device of any one of claims 1 to 4, wherein the indicator element (30) comprises a lighting element.

6. The electronic device of any one of claims 1 to 5, comprising a flexible printed circuit arrangement and an insulating coating (40) co-extruded with the flexible printed circuit arrangement.

7. The electronic device of claim 6, wherein the insulating coating (40) is a sleeve.

8. The electronic device of claim 7, wherein the sleeve is a silica gel tube.

9. The electronic device of any one of claims 1 to 8, comprising a light strip, wherein each electrical unit (16) comprises a LED.

10. The electronic device of any one of claims 1 to 9, wherein the wireless power receiver (32) comprises a receiver inductor (L1) and an AC/DC converter (R1,D1) and the indicator element (30) comprises a LED.

11. A method of manufacturing an electronic device, comprising:
manufacturing an elongate substrate arrangement (13,15) comprising:
a row of electrical units (16); and
an indicator unit (14) comprising an indicator element (30) and a wireless power receiver (32) for wirelessly receiving power for actuating the indicator element (30) thereby to identify a location of the elongate printed circuit substrate arrangement;
passing the elongate printed circuit substrate arrangement (13,15) over a wireless power transmitter (60);
observing the actuation of the indicator element (30) as it passes over the wireless power transmitter; and
marking the location of the indicator element, thereby to identify the location indicated by the indicator element.

12. The method of claim 11, comprising:
assembling a plurality of individual printed circuit substrates (13) each carrying a respective set of electrical units (16) to form the elongate printed circuit substrate arrangement, wherein each individual printed circuit substrate carries (13) at least one indicator element (30); or
assembling a plurality of individual printed circuit substrates (13) and separate printed circuit substrates (15) of the indicator units (14) to form the elongate printed circuit substrate arrangement.

13. The method of claim 12, comprising co-extruding the flexible printed circuit arrangement with an insulating coating (40).

14. The method of claim 13, wherein the insulating coating (40) is a sleeve, for example a silica gel tube.

15. The method of any one of claims 12 to 14 for manufacturing a light strip, wherein each electrical unit comprises a LED.

## Patentansprüche

1. Elektronische Vorrichtung (10), umfassend:
eine längliche Leiterplattensubstratanordnung (13, 15);
eine Reihe von elektrischen Einheiten (16) auf der Leiterplattensubstratanordnung; und eine Anzeigeeinheit (14), die ein Anzeigeelement (30) und einen drahtlosen Leistungsempfänger (32) zum drahtlosen Empfangen von Leistung zur Betätigung des Anzeigeelements umfasst, um dadurch eine bestimmte Position der länglichen Leiterplattensubstratanordnung zu identifizieren; wobei die Reihe von elektrischen Einheiten (16) mehrere Sätze von elektrischen Einheiten umfasst, die zu trennen sind, und die Anzeigeeinheit (14) die Position identifiziert, an der die Trennung stattfinden soll;
wobei jeder Satz von elektrischen Einheiten sein eigenes individuelles Leiterplattensubstrat (13) aufweist, und die individuellen Leiterplattensubstrate (13) miteinander verbunden sind, um die längliche Leiterplattensubstratanordnung zu bilden.

2. Elektronische Vorrichtung nach Anspruch 1, umfassend eine Anzeigeeinheit (14) zwischen jedem benachbarten Paar von Sätzen elektrischer Einheiten (16) entlang der länglichen Leiterplattensubstratanordnung.

3. Elektronische Vorrichtung nach Anspruch 1, wobei jedes individuelle Leiterplattensubstrat (13) mindestens eine Anzeigeeinheit (14) trägt.

4. Elektronische Vorrichtung nach Anspruch 1, wobei die Anzeigeeinheiten (14) separate Vorrichtungen zu den individuellen Leiterplattsubstraten mit separaten Leiterplattsubstraten (15) umfassen, wobei die individuellen Leiterplattsubstrate (13) und die separaten Leiterplattsubstrate (15) miteinander verbunden sind, um die längliche Leiterplattensubstratanordnung (13, 15) zu bilden.

5. Elektronische Vorrichtung nach einem der Ansprüche 1 bis 4, wobei das Anzeigeelement (30) ein Beleuchtungselement umfasst.

6. Elektronische Vorrichtung nach einem der Ansprüche 1 bis 5, umfassend eine flexible Leiterplattenanordnung und eine isolierende Beschichtung (40), die mit der flexiblen Leiterplattenanordnung koextrudiert ist.

7. Elektronische Vorrichtung nach Anspruch 6, wobei die isolierende Beschichtung (40) eine Hülse ist.

8. Elektronische Vorrichtung nach Anspruch 7, wobei die Hülse ein Silikagelschlauch ist.

9. Elektronische Vorrichtung nach einem der Ansprüche 1 bis 8, umfassend einen Lichtstreifen, wobei jede elektrische Einheit (16) eine LED umfasst.

10. Elektronische Vorrichtung nach einem der Ansprüche 1 bis 9, wobei der drahtlose Leistungsempfänger (32) eine Empfängerspule (L1) und einen AC/DC-Wandler (R1, D1) umfasst und das Anzeigeelement (30) eine LED umfasst.

11. Verfahren zum Herstellen einer elektronischen Vorrichtung, umfassend:
Herstellen einer länglichen Substratanordnung (13, 15), umfassend:
eine Reihe von elektrischen Einheiten (16); und
eine Anzeigeeinheit (14), die ein Anzeigeelement (30) und einen drahtlosen Leistungsempfänger (32) zum drahtlosen Empfangen von Leistung zum Betätigen des Anzeigeelements (30) umfasst, um dadurch eine Position der länglichen Leiterplattensubstratanordnung zu identifizieren;
Führen der länglichen Leiterplattensubstratanordnung (13, 15) über einen drahtlosen Leistungsüberträger (60);
Beobachten der Betätigung des Anzeigeelementes (30), wenn es über den drahtlosen Leistungsüberträger geführt wird; und
Markieren der Position des Anzeigeelementes, wodurch die durch das Anzeigeelement angezeigte Position identifiziert wird.

12. Verfahren nach Anspruch 11, umfassend:
Zusammenbauen einer Vielzahl von individuellen Leiterplattensubstraten (13), die jeweils einen entsprechenden Satz von elektrischen Einheiten (16) tragen, um die längliche Leiterplattensubstratanordnung zu bilden, wobei jedes individuelle Leiterplattensubstrat (13) mindestens ein Anzeigeelement (30) trägt; oder
Zusammenbauen einer Vielzahl von individuellen Leiterplattensubstraten (13) und separaten Leiterplattensubstraten (15) der Anzeigeeinheiten (14) zum Bilden der länglichen Leiterplattensubstratanordnung.

13. Verfahren nach Anspruch 12, umfassend das Koextrudieren der flexiblen Leiterplattenanordnung mit einer isolierenden Beschichtung (40).

14. Verfahren nach Anspruch 13, wobei die isolierende Beschichtung (40) eine Hülse ist, zum Beispiel ein Silikagelschlauch.

15. Verfahren nach einem der Ansprüche 12 bis 14 zum Herstellen eines Lichtstreifens, wobei jede elektrische Einheit eine LED umfasst.

## Revendications

1. Dispositif électronique (10) comprenant :
un agencement de substrats de circuits imprimés allongé (13,15) ;
une rangée d'unités électriques (16) sur l'agencement de substrats de circuits imprimés ; et
une unité indicatrice (14) comprenant un élément indicateur (30) et un récepteur d'énergie sans fil (32) pour recevoir sans fil de l'énergie afin d'actionner l'élément indicateur, identifiant de ce fait un emplacement particulier de l'agencement de substrats de circuits imprimés allongé ; dans lequel la rangée d'unités électriques (16) comprend plusieurs ensembles d'unités électriques qui doivent être séparées, et l'unité indicatrice (14) identifie l'emplacement où la séparation doit avoir lieu ;
dans lequel chaque ensemble d'unités électriques possède son propre substrat de circuits imprimés individuel (13), et les substrats de circuits imprimés individuels (13) sont connectés ensemble pour former l'agencement de substrats de circuits imprimés allongé.

2. Dispositif électronique selon la revendication 1, comprenant une unité indicatrice (14) entre chaque paire adjacente d'ensembles d'unités électriques (16) le long de l'agencement de substrats de circuits imprimés allongé.

3. Dispositif électronique selon la revendication 1, dans lequel chaque substrat de circuits imprimés individuel (13) porte au moins une unité indicatrice (14).

4. Dispositif électronique selon la revendication 1, dans lequel les unités indicatrices (14) comprennent des dispositifs séparés pour les substrats de circuits imprimés individuels avec des substrats de circuits imprimés séparés (15), dans lequel les substrats de circuits imprimés individuels (13) et les substrats de circuits imprimés séparés (15) sont connectés ensemble pour former l'agencement de substrats de circuits imprimés allongé (13,15).

5. Dispositif électronique selon l'une quelconque des revendications 1 à 4, dans lequel l'élément indicateur (30) comprend un élément d'éclairage.

6. Dispositif électronique selon l'une quelconque des revendications 1 à 5, comprenant un agencement de circuits imprimés flexibles et un revêtement isolant (40) coextrudé avec l'agencement de circuits imprimés flexibles.

7. Dispositif électronique selon la revendication 6, dans lequel le revêtement isolant (40) est un manchon.

8. Dispositif électronique selon la revendication 7, dans lequel le manchon est un tube de gel de silice.

9. Dispositif électronique selon l'une quelconque des revendications 1 à 8, comprenant une bande lumineuse, dans lequel chaque unité électrique (16) comprend une DEL.

10. Dispositif électronique selon l'une quelconque des revendications 1 à 9, dans lequel le récepteur d'énergie sans fil (32) comprend un inducteur de récepteur (L1) et un convertisseur CA/CC (R1, D1) et l'élément indicateur (30) comprend une DEL.

11. Procédé de fabrication d'un dispositif électronique, comprenant :
la fabrication d'un agencement de substrats allongé (13, 15) comprenant :
une rangée d'unités électriques (16) ; et
une unité indicatrice (14) comprenant un élément indicateur (30) et un récepteur d'énergie sans fil (32) pour recevoir sans fil de l'énergie afin d'actionner l'élément indicateur (30) et identifier de ce fait un emplacement de l'agencement de substrats de circuits imprimés allongé ;
faire passer l'agencement de substrats de circuits imprimés allongé (13, 15) au-dessus d'un émetteur d'énergie sans fil (60) ;
observer l'actionnement de l'élément indicateur (30) lorsqu'il passe au-dessus de l'émetteur d'énergie sans fil ; et
marquer l'emplacement de l'élément indicateur, pour identifier de ce fait l'emplacement indiqué par l'élément indicateur.

12. Procédé selon la revendication 11 comprenant :
l'assemblage d'une pluralité de substrats de circuits imprimés individuels (13) portant chacun un ensemble respectif d'unités électriques (16) pour former l'agencement de substrats de circuits imprimés allongé, dans lequel chaque substrat de circuits imprimés individuel (13) porte au moins un élément indicateur (30) ; ou
l'assemblage d'une pluralité de substrats de circuits imprimés individuels (13) et de substrats de circuits imprimés séparés (15) des unités indicatrices (14) pour former l'agencement de substrat de circuits imprimés allongé.

13. Procédé selon la revendication 12, comprenant la coextrusion de l'agencement de circuits imprimés flexibles avec un revêtement isolant (40).

14. Procédé selon la revendication 13, dans lequel le revêtement isolant (40) est un manchon, par exemple un tube de gel de silice.

15. Procédé selon l'une quelconque des revendications 12 à 14 pour la fabrication d'une bande lumineuse, dans lequel chaque unité électrique comprend une DEL.
